(19) Europäisches Patentamt
European Patent Office
Office européen des brevets

(11) **EP 2 987 843 A1**

(12) **EUROPEAN PATENT APPLICATION**
published in accordance with Art. 153(4) EPC

(43) Date of publication:
**24.02.2016 Bulletin 2016/08**

(21) Application number: **14785293.3**

(22) Date of filing: **07.02.2014**

(51) Int Cl.:
**C09K 11/80** (2006.01)  **H01L 33/50** (2010.01)

(86) International application number:
**PCT/JP2014/052898**

(87) International publication number:
**WO 2014/171170 (23.10.2014 Gazette 2014/43)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **16.04.2013  JP 2013085882**

(71) Applicant: **Denki Kagaku Kogyo Kabushiki Kaisha
Tokyo 103-8338 (JP)**

(72) Inventors:
• **KOBAYASHI Keita
Omuta-city
Fukuoka 836-8510 (JP)**

• **FUSHII Yasuhito
Omuta-city
Fukuoka 836-8510 (JP)**
• **SAKO Sohma
Omuta-city
Fukuoka 836-8510 (JP)**

(74) Representative: **Gulde & Partner
Patent- und Rechtsanwaltskanzlei mbB
Wallstraße 58/59
10179 Berlin (DE)**

(54) **PHOSPHOR, LIGHT EMITTING DEVICE AND LIGHTING DEVICE**

(57)     An object of the present invention is to provide a phosphor emitting yellow light having much red and green components and a light-emitting device comprising the phosphor that is superior in color rendering property.

The present invention provides a phosphor having a garnet structure represented by General Formula: $Lu_aCe_bAl_cSi_dO_eN_f$. However in the General Formula above, a to f satisfy the following conditions: $1.50 \leq a \leq 3.15$; $0.05 \leq b \leq 1.50$; $2 \leq a+b \leq 4$; $4.0 \leq c \leq 7.0$; $0.0 < d < 0.1$; $7.0 \leq e \leq 16.0$; $0.001 \leq f \leq 1.0$; and $10 \leq e+f \leq 16$.

[Fig. 1]

EP 2 987 843 A1

**Description**

Technical Field

The present invention relates to a phosphor, a light-emitting device, and a lighting device.

Background Art

Patent Document 1 discloses a green phosphor made of LuAG: Ce.
Patent Document 2 discloses a colored- and white-light-generating lighting device made of LuAG: Ce that converts blue or UV light into green light.

Citation List

Patent Literatures

    [Patent Document 1] JP-A No. 2012-062444
    [Patent Document 2] JP-T No. 2009-539219

Summary of Invention

Technical Problem

However, there existed a new problem that, when green and red phosphors are used, as mixed, in a white-light-emitting lighting device to increase the color rendering property while preserving the red and green components thereof, the light emitted from one phosphor is absorbed by another phosphor, resulting in deterioration of luminous efficiency.
Accordingly, an object of the present invention is to provide a phosphor emitting yellow light containing much red and green components, and a light-emitting device and a lighting device comprising the phosphor with favorable color rendering property.

Solution to Problem

After intensive studies, the inventors have found that it is possible, by adding cerium atoms in a great amount and additionally nitrogen and silicon atoms in suitable amounts to a compound containing an activator of rare earth element having a garnet structure, to produce a compound containing a much red component due to increase in the chromaticity X, peak wavelength, and half value width thereof and, by using the compound, to provide a phosphor containing red and green components, and made the present invention.
The present invention provides a phosphor having a garnet structure represented by the General Formula: $Lu_aCe_bAl_cSi_dO_eN_f$ (wherein, a to f satisfy the following conditions):

$$1.50 \leq a \leq 3.15;$$

$$0.05 \leq b \leq 1.50;$$

$$2 \leq a{+}b \leq 4;$$

$$4.0 \leq c \leq 7.0;$$

$$0.0 < d < 0.1;$$

$$7.0 \le e \le 16.0;$$

$$0.001 \le f \le 1.0;$$

and

$$10 \le e+f \le 16.$$

According to the present invention, part of Lu may be substituted with one or more elements selected from Y, Sc, La, Gd, and Sm. In addition, part of Ce may be substituted with one or more elements selected from Pr, Nd, Eu, Tb, Dy, Ho, Er, Tm, Yb, Bi, and Mn, and part of Al may be substituted with one or both of Ga and In. The present invention may contain two or more elements selected from F, Cl, Li, Na, Mg, Nd, Ca, Ba, and B as flux component during sintering.

The present invention relates to a light-emitting element, a light-emitting device comprising the phosphor, and a lighting device comprising the light-emitting device.

Advantageous Effects of Invention

The present invention provides a phosphor emitting yellow light containing much red and green components, and a light-emitting device and a lighting device comprising the phosphor with favorable color rendering property.

Brief Description of Drawings

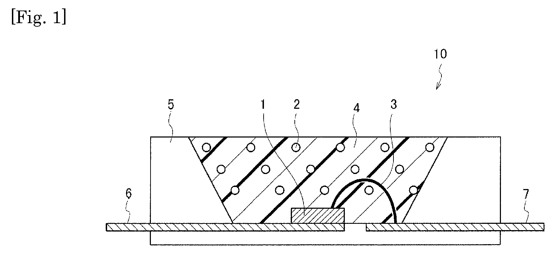

Figure 1 is a drawing (regional sectional view) schematically explaining the light-emitting device in the second embodiment of the present invention.

Description of Embodiments

Hereinafter, favorable embodiments of the present invention will be described.

The first embodiment of the present invention relates to a phosphor having a garnet structure represented by the General Formula: $Lu_a Ce_b Al_c Si_d O_e N_f$ (wherein, a to f satisfy the following conditions):

$$1.50 \le a \le 3.15;$$

$$0.05 \le b \le 1.50;$$

$$2 \le a+b \le 4;$$

$$4.0 \le c \le 7.0;$$

$$0.0 < d < 0.1;$$

$$7.0 \le e \le 16.0;$$

$$0.001 \le f \le 1.0;$$

and

$$10 \leq e+f \leq 16.$$

The phosphor of the present embodiment has an advantage that it contains much red and green components although it emits a yellow light. It is preferably a yellow-light-emitting phosphor containing red and green components higher in chromaticity X, peak wavelength, and half value width.

In the phosphor of the present embodiment, part of Lu is preferably substituted with one or more elements selected from Y, Sc, La, Gd, and Sm; part of Ce is preferably substituted with one or more elements selected from Pr, Nd, Eu, Tb, Dy, Ho, Er, Tm, Yb, Bi, and Mn; and part of Al is preferably substituted with one or both of Ga and In. The phosphor of the present embodiment preferably contain two or more elements selected from F, Cl, Li, Na, Mg, Nd, Ca, Ba, and B as flux component during sintering.

Preferably, the phosphor of the present embodiment is essentially consists of Lu, Ce, Al, Si, O and N.

The garnet structure is a crystal structure identical in shape with the crystal structure represented by garnet ($A_3B_5O_{12}$; A is one or more bivalent metal ions selected from the group consisting of Ca, Mg, and Fe; B is one or more trivalent metal ions selected from the group consisting of Al, Fe, and Cr; and O is oxygen).

In the phosphor of the present embodiment, Lu represents lutetium, Y represents yttrium, Sc represents scandium, La represents lanthanum, Gd represents gadolinium, Sm represents samarium, Ce represents cerium, Pr represents praseodymium, Nd represents neodymium, Eu represents europium, Tb represents terbium, Dy represents dysprosium, Ho represents holmium, Er represents erbium, Tm represents thulium, Yb represents ytterbium, Bi represents bismuth, Mn represents manganese, Al represents aluminum, Ga represents gallium, In represents indium, O represents oxygen, Si represents silicon, N represents nitrogen, F represents fluorine, Cl represents chlorine, Li represents lithium, Na represents sodium, Mg represents magnesium, Ca represents calcium, Ba represents barium, and B represents boron.

When the value a of Lu is too small, there is observed no advantageous effects by the presence of Lu. Alternatively when it is too large, the content of cerium declines relatively, resulting in decrease of the amount of the red component. Thus, a is 1.50 or more and 3.15 or less. The composition ratio a of Lu is preferably 1.50 or more and 2.95 or less, more preferably 1.50 or more and 2.80 or less.

When the value b of Ce is too small, the content of red component decreases; when it is large, the content of red component increases; and when it is too large, the light intensity declines distinctively. Thus b is 0.05 or more and 1.50 or less, and the preferable lower limit value is 0.3. The composition ratio b of Ce is more preferably 0.25 or more and 1.50 or less, further more preferably 0.30 or more and 1.50 or less.

When the sum of a and b (a+b) is too small, the light intensity declines distinctively; and, when it is too large, the light intensity also declines distinctively. Thus it is 2 or more and 4 or less, preferably 2.5 or more and 3.5 or less.

When the value c of Al is too small, the light intensity declines distinctively. Thus, it is 4.0 or more and 7.0 or less, preferably 5.0 or more and 7.0 or less.

When the value d of silicon is 0.0, the content of red component is small. Alternatively when it is too large, the light intensity declines distinctively. Thus, it is more than 0.0 and less than 0.1. The composition ratio d of Si is preferably 0.001 or more and 0.095 or less.

When the value e of O is too small, the light intensity declines distinctively. Alternatively when it is too large, the light intensity also declines. Thus it is 7.0 or more and 16.0 or less. The composition ratio e of O is preferably 11.0 or more and 16.0 or less, more preferably 11.0 or more and 15.5 or less.

When the value f of N is 0.0, the content of red component is small; when it is large, the content of red component increases; and when it is too large, the light intensity declines. Thus it is 0.001 or more and 1.0 or less. The composition ratio f of N is preferably 0.001 or more and 0.7 or less, more preferably 0.001 or more and 0.4 or less, further more preferably 0.001 or more and 0.2 or less.

When the sum of e and f (e+f) is too small, the light intensity declines distinctively. Alternatively when it is too large, the light intensity also declines. Thus it is 10 or more and 16 or less. The sum of e and f is preferably 11 or more and 16 or less, more preferably 11.0 or more and 15.5 or less.

The nitrogen atoms of the phosphor are present either or both in the crystal lattice and in the space between the crystal lattices of the phosphor having a garnet structure. The silicon atoms are present in the crystal lattice of the phosphor having a garnet structure.

The phosphor of the present embodiment is produced by mixing components respectively containing Lu, Ce, Al, Si, O, and N and sintering the mixture.

In production of the phosphor, the raw material mixture powder is preferably sintered under a pressurized nitrogen environment. The sintering may be carried out under an argon atmosphere. The pressure applied is preferably 0.1 MPa or more and 10 MPa or less, more preferably 0.1 MPa or more and 2 MPa or less, further more preferably 0.5 MPa or more and 1.5 MPa or less. The sintering temperature is preferably 1000°C or higher and 2400°C or lower, more preferably 1200°C or higher and 2000°C or lower, further more preferably 1300°C or higher and 1700°C or lower. The sintering period is preferably 0.5 hours or more and 30 hours or less, more preferably 1 hour or more and 24 hours or less.

In production of the phosphor of the present embodiment, a flux may be added during sintering. The flux used may be a chloride or fluoride. Examples of the flux include $LiF$, $NaF$, $AlF_3$, $YF_3$, $YbF_3$, $GdF_3$, $MgF_2$, $SmF_3$, $CeF_3$, $NdF_3$, $CaF_2$, $LaF_3$, $BaF_2$, $TbF_3$, $B_2O_3$, and $H_3BO_3$.

The second embodiment of the present invention relates to a light-emitting element and a light-emitting device comprising the phosphor described above.

The light-emitting element is preferably a device emitting a light having a wavelength in the range of 350 nm to 500 nm. The phosphor used in the light-emitting device may be that described above or a phosphor having another emission color such as red or green-light emitting phosphor.

Examples of the light-emitting device include light-emitting devices having a LED as light-emitting element and a phosphor deposited on the LED-emitting face thereof, lighting devices having such a light-emitting device, and imaging devices having such a light-emitting device. Examples of the lighting devices include spherical electric lamp-type lighting devices and rod-shaped fluorescent lamp-type lighting devices. Examples of the imaging device include television sets, computer monitors, portable terminal devices, cell phones, and video game computers.

Figure 1 is a drawing showing an example of the configuration of the light-emitting device of the present embodiment. However, it should be understood that the light-emitting device according to the present invention is not limited thereto. As shown in Figure 1, the light-emitting device 10 of the present embodiment has a light-emitting element 1 (for example, blue LED chip) and a phosphor 2 deposited on the light-emitting face of the light-emitting device. The phosphor according to the present invention described above is used as part or all of the phosphor 2.

The fluorescence element 1 used may be a LED such as an ultraviolet-ray emitting diode (UV-LED) or a blue light-emitting diode (blue LED), a fluorescent lamp, a laser diode (LD), or the like. Use of a LED is favorable. The phosphor 2 used may be completely the phosphor according to the present invention described above , however, a red, orange, yellow, green, blue, and/or other light-emitting phosphor may also be used in combination. It is thus possible to adjust the color of the light emitted from the light-emitting device.

The light-emitting device 10 of the present embodiment has a light-emitting element 1 formed on a conductive terminal (lead frame) 6 and the light-emitting element 1 is sealed with a sealing resin 4 containing dispersed phosphor 2, as it is placed in a container (casing) 5 on the conductive terminal 6. The light-emitting device 1 is connected to another conductive terminal (lead frame) 7 by a conductive wire (bonding wire) 3.

The light-emitting device may be coated (molded) with an arbitrary visible light-transmitting resin on the periphery thereof. The visible light-transmitting resin is, for example, an epoxy resin, a urethane resin or a silicone resin. The visible light-transmitting resin may contain, as needed, additives such as viscosity improvers, diffusing agent, and ultraviolet absorbents.

The light-emitting device may have an external shape such as of cannonball, chip, or multi-segment article.

In the light-emitting device 10 of the present embodiment, the light-emitting element 1 emits an excitation light having a wavelength of 350 to 500 nm, which irradiates the phosphor 2. The phosphor 2 emits, as excited by the excitation light, a light having peak in a wavelength region of 540 nm or more (favorably 540 to 560 nm, more favorably 541 to 555 nm). The phosphor 2 used in the light-emitting device 10 of the present embodiment is superior in external quantum efficiency, chromaticity, and color rendering index (Ra). A favorable phosphor 2 has an external quantum efficiency of 63% or more, a chromaticity X of 0.37 or more (more favorably a chromaticity X of 0.370 to 0.399), and a color rendering index (Ra) of 69.0 or more. The light-emitting device 10 of the present embodiment can emit a yellow light having much red and green components and is thus superior in color rendering property.

The third embodiment of the present invention relates to a lighting device comprising a light-emitting device containing the phosphor according to the present invention. The lighting device has at least one light-emitting device comprising the phosphor according to the present invention.

The lighting device is, for example, a device wherein the AC input terminal of a lighting module is connected to power supply and one or more light-emitting devices are connected, in series or in parallel, to the DC output terminal of the lighting module.

Examples of the lighting device include electric lamp-type devices, fluorescent lamp-type devices, down light-type devices, and surface lighting-type devices.

The lighting device of the present embodiment has a light-emitting device coated with a transparent resin and a circuit board controlling the light-emitting device.

The lighting device, which contains the phosphor described above, emits yellow light containing much red and green components and is thus superior in color rendering property.

Examples

Examples of the phosphor, the light-emitting device, and the lighting device according to the present invention will be described together with Comparative Examples with reference to Table 1 and Figure 1.

[Example 1]

As shown in Table 1, the phosphor of Example 1 is represented by $Lu_aCe_bAl_cSi_dO_eN_f$, wherein a = 2.70, b = 0.30, a+b = 3.0, c = 5.00, d = 0.001, e = 12.15, f = 0.0013, and, e+f = 12.1513.

The composition, external quantum efficiency, chromaticity X, peak wavelength, half value width, and color rendering index (Ra) of the phosphor prepared in Example 1 are summarized in Table 1.

The values of the phosphor composition shown in Table 1 are target values when the raw materials were blended.

[Table 1]

| | | Example | | | | | | | | | | | Comparative Example | | | | |
|---|---|---|---|---|---|---|---|---|---|---|---|---|---|---|---|---|---|
| | | 1 | 2 | 3 | 4 | 5 | 6 | 7 | 8 | 9 | 10 | 11 | 1 | 2 | 3 | 4 | 5 |
| Phosphor composition | Lu:a | 2.70 | 2.70 | 2.70 | 2.70 | 1.50 | 2.95 | 2.25 | 3.15 | 2.70 | 2.70 | 1.50 | 2.70 | 2.70 | 1.00 | 2.99 | 2.70 |
| | Ce:b | 0.30 | 0.30 | 0.30 | 0.30 | 1.50 | 0.05 | 0.25 | 0.35 | 0.30 | 0.30 | 1.50 | 0.30 | 0.30 | 2.00 | 0.01 | 0.30 |
| | Al:c | 5.00 | 5.00 | 5.00 | 5.00 | 5.00 | 5.00 | 5.00 | 5.00 | 4.00 | 7.00 | 5.00 | 5.00 | 5.00 | 5.00 | 5.00 | 3.00 |
| | Si:d | 0.001 | 0.010 | 0.050 | 0.095 | 0.010 | 0.010 | 0.010 | 0.010 | 0.010 | 0.010 | 0.010 | 0.00 | 0.20 | 0.01 | 0.01 | 0.01 |
| | O:e | 12.15 | 12.15 | 12.15 | 12.15 | 12.75 | 12.025 | 11.375 | 12.925 | 10.65 | 15.15 | 12.75 | 12.15 | 12.15 | 13.00 | 12.005 | 9.15 |
| | N:f | 0.0013 | 0.013 | 0.067 | 0.127 | 0.013 | 0.013 | 0.013 | 0.013 | 0.013 | 0.013 | 0.013 | 0.000 | 0.267 | 0.013 | 0.013 | 0.013 |
| External quantum efficiency (%) | | 77.5 | 75.2 | 70.3 | 65.4 | 72.3 | 70.1 | 74.1 | 69.8 | 63.8 | 76.4 | 64.5 | 71.2 | 62.4 | 60.7 | 65.9 | 59.3 |
| Chromaticity X | | 0.377 | 0.379 | 0.385 | 0.398 | 0.408 | 0.370 | 0.382 | 0.377 | 0.375 | 0.382 | 0.375 | 0.365 | 0.400 | 0.400 | 0.367 | 0.369 |
| Peak wavelength (nm) | | 542.9 | 543.7 | 544.8 | 548.5 | 551.2 | 541.7 | 544.7 | 542.7 | 542.8 | 544.3 | 543.1 | 540.3 | 549.1 | 548.7 | 540.7 | 540.9 |
| Half value width (nm) | | 108.2 | 108.4 | 109.5 | 113.7 | 116.0 | 106.1 | 109.4 | 108.2 | 106.7 | 108.7 | 107.1 | 104.2 | 114.3 | 113.4 | 104.7 | 105.4 |
| Color rendering index (Ra) | | 69.5 | 69.8 | 70.4 | 71.6 | 72.5 | 69.1 | 70.1 | 69.6 | 69.4 | 69.7 | 69.7 | 68.3 | 71.7 | 71.6 | 68.6 | 68.7 |
| Raw material composition | Lu₂O₃ | 60.48 | 60.45 | 60.29 | 60.12 | 34.91 | 65.52 | 57.00 | 63.18 | 64.33 | 53.93 | 36.75 | 60.49 | 59.71 | 23.67 | 66.33 | 68.75 |
| | Al₂O₃ | 28.70 | 28.68 | 28.61 | 28.52 | 29.82 | 28.46 | 32.45 | 25.69 | 24.42 | 35.83 | 31.39 | 28.70 | 28.33 | 30.32 | 28.42 | 19.57 |
| | CeO₂ | 5.81 | 5.81 | 5.79 | 5.78 | 30.20 | 0.96 | 5.48 | 6.07 | 6.18 | 5.18 | 31.79 | 5.81 | 5.74 | 40.95 | 0.19 | 6.61 |
| | S₃N₄ | 0.0053 | 0.0615 | 0.3067 | 0.5810 | 0.0639 | 0.0610 | 0.0696 | 0.0551 | 0.0654 | 0.0549 | 0.0673 | 0.0000 | 1.2149 | 0.0650 | 0.0609 | 0.0699 |
| | BaF₂ | 5.00 | 5.00 | 5.00 | 5.00 | 5.00 | 5.00 | 5.00 | 5.00 | 5.00 | 5.00 | 0.00 | 5.00 | 5.00 | 5.00 | 5.00 | 5.00 |
| Sintering environments | | N₂ | N₂ | N₂ | N₂ | N₂ | N₂ | N₂ | N₂ | N₂ | N₂ | N₂ | vacuum | N₂ | N₂ | N₂ | N₂ |

<External quantum efficiency>

In the present test, the luminous efficiency (external quantum efficiency) was measured using a spectrophotometer (MCPD-7000 manufactured by Otsuka Electronics Co., Ltd.) and calculated according to the following procedure:

The phosphor of Example 1 was filled into a concave cell with the surface thereof flattened and an integrating sphere was placed thereon. A monochromatic light having a wavelength of 455 nm was introduced into the integrating sphere via an optical fiber from a Xe lamp as light source. The phosphor sample of Example 1 was irradiated by the monochromatic light as excitation source and the fluorescence spectrum of the light from the sample was determined. The luminous efficiency was determined in the following manner:
A standard reflector having a reflectivity of 99% (Spectralon manufactured by Labsphere) was placed in the sample unit and the spectrum of the excitation light having a wavelength of 455 nm was determined. Then, the excitation light photon number (Qex) was calculated from the spectrum of the light having a wavelength range of 450 nm to 465 nm.

Then, a sample was placed in the sample unit and the excited reflected light photon number (Qref) and the fluorescence photon number (Qem) were calculated from the spectrum data obtained.

The excited reflected light photon number was calculated in the wavelength range identical with that for the excitation light photon number, while the fluorescence photon number was calculated in the range of 465 nm to 800 nm. The external quantum efficiency (Qem/Qex×100), absorbance ((Qex-Qref)/Qex×100), internal quantum efficiency (Qem/(Qex-Qref)×100) were determined from the three kinds of photon numbers obtained.

The external quantum efficiency satisfactory in Examples is 63% or more.

<Chromaticity X (CIEx)>

In the present test, the chromaticity X, a value of CIE1931 (XYZ standard colorimetric system), was determined using the spectrophotometer described above (MCPD-7000, manufactured by Otsuka Electronics Co., Ltd.). The chromaticity X (CIEx) was determined by measuring the fluorescence spectrum of the entire light flux of the fluorescent light obtained by excitation at 455 nm on an instantaneous multichannel photodetector (MCPD-7000, manufactured by Otsuka Electronics Co., Ltd.) using an integrating sphere. Measurement was performed according to a reference literature, Kazuaki Ohkubo et al., "Absolute Fluorescent Quantum Efficiency of NBS Phosphor Standard Samples," Journal of the Illuminating Engineering Institute of Japan, 83, 2, pp.87-93, 1999.

The chromaticity X satisfactory in Examples is 0.370 or more.

<Peak wavelength>

In the present test, the peak wavelength was determined using a spectrophotometer (MCPD-7000, manufactured by Otsuka Electronics Co., Ltd.). A sample phosphor was filled into a concave cell with the surface flattened and an integrating sphere was placed thereon. A monochromatic blue light having a wavelength of 455 nm was introduced into the integrating sphere via an optical fiber from an emission light source Xe lamp. The monochromatic light was emitted as excitation source to the phosphor sample and the fluorescence spectrum of the light from the sample was measured. The peak wavelength was determined from the fluorescence spectrum obtained.

The peak wavelength satisfactory in Examples is 541.0 nm or more.

<Half value width>

The half value width was determined using a spectrophotometer (MCPD-7000, manufactured by Otsuka Electronics Co., Ltd.). The half value width was determined from the fluorescence spectrum obtained by the "fluorescence spectrum measurement" explained in the measurement of the peak wavelength described above.

The half value width satisfactory in Examples is 106.0 nm or more.

<Color rendering index (Ra)>

In the present test, the color rendering index is determined, as the phosphor was integrated with a surface-mounted LED (white LED) shown in Figure 1, and the phosphor was evaluated based on the average color rendering index (Ra).

The surface-mounted LED shown in Figure 1 is an article prepared by placing a blue LED chip 1, as connected to a conductive terminal 6, on the bottom in a container 5, connecting the blue LED chip 1 having an emission wavelength of 460 nm via a wire 3 to another conductive terminal 7, pouring an epoxy resin (NLD-SL-2101, produced by Sanyu Rec Co., Ltd.) containing the phosphor 2 of Example 1 as sealing resin 4 into the container 5, and hardening the composite under heat.

The average color rendering index (Ra) was determined by measuring the emission spectrum of the light generated when a current of 10 mA was applied to the surface-mounted LED.

The average color rendering index (Ra) satisfactory in Examples is 69.0 or more.

<Preparative method>

(Raw materials)

As shown in the column of raw material composition of Table 1, raw materials for the phosphor of Example 1 are $Lu_2O_3$ (produced by Wako Pure Chemical Industries Ltd., 60.48 mass %), $CeO_2$ (Wako special grade, produced by Wako Pure Chemical Industries Ltd., 5.81 mass %), $Al_2O_3$ (TM-DAR grade, produced by Taimei Chemicals Co., Ltd., 28.70 mass %), $S_3N_4$ (NP-400 grade, produced by Denka Co., Ltd., oxygen-content: 0.96 mass %, 0.0053 mass %), and $BaF_2$ (manufactured by Wako Pure Chemical Industries Ltd., 5.00 mass %). The raw materials used were those obtained by classifying the mixture of these raw materials through a nylon sieve having an opening of 850 $\mu$m.

(Sintering step)

The raw material mixture after classification was filled into a cylindrical boron nitride container having an internal size of 8 cm diameter × 8 cm height equipped with a cap (N-1 grade, manufactured by Denka Co., Ltd.) and sintered in an electric furnace at 1500°C under a pressurized (0.7 MPa) nitrogen atmosphere for 15 hours.

The phosphor after sintering was allowed to cool gradually to room temperature, pulverized, and classified through a sieve having an opening of 250 $\mu$m. The phosphor after classification was used as the phosphor of Example 1.

[Example 2]

As shown in Table 1, the phosphor of Example 2 is that represented by $Lu_aCe_bAl_cSi_dO_eN_f$, wherein a = 2.70, b = 0.30, c = 5.00, d = 0.01, e = 12.15, and f = 0.013. The phosphor of Example 2 was prepared similarly to Example 1 in the raw material composition shown in Table 1.

[Example 3]

As shown in Table 1, the phosphor of Example 3 is that represented by $Lu_aCe_bAl_cSi_dO_eN_f$, wherein a = 2.70, b = 0.30, c = 5.00, d = 0.05, e = 12.15, and f = 0.067. The phosphor of Example 3 was prepared similarly to Example 1 in the raw material composition shown in Table 1.

[Example 4]

As shown in Table 1, the phosphor of Example 4 is that represented by $Lu_aCe_bAl_cSi_dO_eN_f$, wherein a = 2.70, b = 0.30, c = 5.00, d = 0.095, e = 12.15, and f = 0.127. The phosphor of Example 4 was prepared similarly to Example 1 in the raw material composition shown in Table 1.

[Example 5]

As shown in Table 1, the phosphor of Example 5 is that represented by $Lu_aCe_bAl_cSi_dO_eN_f$, wherein a = 1.50, b = 1.50, c = 5.00, d = 0.010, e = 12.75, and f = 0.013. The phosphor of Example 5 was prepared similarly to Example 1 in the raw material composition shown in Table 1.

[Example 6]

As shown in Table 1, the phosphor of Example 6 is that represented by $Lu_aCe_bAl_cSi_dO_eN_f$, wherein a = 2.95, b = 0.05, c = 5.00, d = 0.010, e = 12.025, and f = 0.013. The phosphor of Example 6 was prepared similarly to Example 1 in the raw material composition shown in Table 1.

[Example 7]

As shown in Table 1, the phosphor of Example 7 is that represented by $Lu_aCe_bAl_cSi_dO_eN_f$, wherein a = 2.25, b = 0.25, c = 5.00, d = 0.010, e = 11.375, and f = 0.013. The phosphor of Example 7 was prepared similarly to Example 1 in the raw material composition shown in Table 1.

[Example 8]

As shown in Table 1, the phosphor of Example 8 is that represented by $Lu_aCe_bAl_cSi_dO_eN_f$, wherein a = 3.15, b = 0.35, c = 5.00, d = 0.010, e = 12.925, and f = 0.013. The phosphor of Example 8 was prepared similarly to Example 1 in the raw material composition shown in Table 1.

[Example 9]

As shown in Table 1, the phosphor of Example 9 is that represented by $Lu_aCe_bAl_cSi_dO_eN_f$, wherein a = 2.70, b = 0.30, c = 4.00, d = 0.010, e = 10.65, and f = 0.013. The phosphor of Example 9 was prepared similarly to Example 1 in the raw material composition shown in Table 1.

[Example 10]

As shown in Table 1, the phosphor of Example 10 is that represented by $Lu_aCe_bAl_cSi_dO_eN_f$, wherein a = 2.70, b = 0.30, c = 7.00, d = 0.010, e = 15.15, and f = 0.013. The phosphor of Example 10 was prepared similarly to Example 1 in the raw material composition shown in Table 1.

[Example 11]

As shown in Table 1, the phosphor of Example 11 is that represented by $Lu_aCe_bAl_cSi_dO_eN_f$, wherein a = 1.50, b = 1.50, c = 5.00, d = 0.010, e = 12.75, and f = 0.013. The phosphor of Example 11 was prepared similarly to Example 1 in the raw material composition shown in Table 1, except that the blending rate of $BaF_2$ as flux was 0.00.

The phosphors of Examples 1 to 11 were superior in all test items of external quantum efficiency, chromaticity X, peak wavelength, half value width, and color rendering index (Ra). The phosphors of these Examples had an external quantum efficiency in the range of 63 to 78%, a chromaticity X in the range of 0.37 to 0.41, a peak wavelength in the range of 541 to 552 nm, a half value width in the range of 106 to 116 nm, and a color rendering index (Ra) in the range of 69 to 73.

[Other Examples]

Although not shown in Table 1, the phosphor of Example 12 is the phosphor of Example 1 of which part of Lu was substituted with Y, while the phosphor of Example 13 is the phosphor of Example 1 of which part of Lu was substituted with Gd. The phosphor of any one of the Examples above showed favorable effects similar to those of Example 1, except that it had a peak wavelength and a chromaticity X increased from those of Example 1.

Although not shown in Table 1, the phosphor of Example 14 is the phosphor of Example 1 of which part of Ce was substituted with Eu, while the phosphor of Example 15 is the phosphor of Example 1 of which part of Ce was substituted with Mn. The phosphors respectively showed advantageous effects similar to those of Example 1.

Although not shown in Table 1, the phosphor of Example 16 is the phosphor of Example 1 of which part of Al was substituted with Ga, while the phosphor of Example 17 is the phosphor of Example 1 of which part of Al was substituted with In. The phosphors respectively showed advantageous effects similar to those of Example 1.

Although not shown in Table 1, the phosphor of Example 18 is a phosphor obtained, as F and Ba were introduced as flux components into the sintering furnace in the sintering step of Example 1, while the phosphor of Example 19 is a phosphor obtained, as F and Ca were introduced as flux components into the sintering furnace in the sintering step of Example 1. Each phosphor showed enhanced grain growth, and the phosphor of Example 18 had an external quantum efficiency of 79.1, while the phosphor of Example 19 had an external quantum efficiency of 78.8. The external quantum efficiencies of the phosphors of Examples 18 and 19 were higher than that of Example 1.

[Comparative Example 1]

As shown in Table 1, the phosphor of Comparative Example 1 is that represented by $Lu_aCe_bAl_cSi_dO_eN_f$, wherein a = 2.70, b = 0.30, c = 5.00, d = 0.00, e = 12.15, and f = 0.00 and thus the values of d and f were outside the scope of the present invention. The phosphor of Comparative Example 1 was prepared similarly to Example 1, except that it had the raw material composition shown in Table 1 and the atmosphere in the sintering step was changed to a vacuum atmosphere at an absolute pressure of 5.0 Pa. Because of the difference, the phosphor of Comparative Example 1 had an oxygen rate of 0.00. The phosphor of Comparative Example 1 was unfavorable in chromaticity X, half value width, and color rendering index (Ra).

[Comparative Example 2]

As shown in Table 1, the phosphor of Comparative Example 2 is that represented by $Lu_aCe_bAl_cSi_dO_eN_f$, wherein a = 2.70, b = 0.30, c = 5.00, d = 0.20, e = 12.15, and f = 0.267 and thus the value of d was outside the scope of the present invention. The phosphor of Comparative Example 2 was prepared similarly to Example 1, except that it had the raw material composition shown in Table 1. The phosphor of Comparative Example 2 was unfavorable in external quantum efficiency.

[Comparative Example 3]

As shown in Table 1, the phosphor of Comparative Example 3 is that represented by $Lu_aCe_bAl_cSi_dO_eN_f$, wherein a = 1.00, b = 2.00, c = 5.00, d = 0.01, e = 13.00, and f = 0.013 and thus the values of a and b were outside the scope of the present invention. The phosphor of Comparative Example 3 was prepared similarly to Example 1, except that it had the raw material composition shown in Table 1. The phosphor of Comparative Example 3 was unfavorable in external quantum efficiency.

[Comparative Example 4]

As shown in Table 1, the phosphor of Comparative Example 4 is that represented by $Lu_aCe_bAl_cSi_dO_eN_f$, wherein, a = 2.99, b = 0.01, c = 5.00, d = 0.01, e = 12.005, and f = 0.013 and thus the value of b was outside the scope of the present invention. The phosphor of Comparative Example 4 was prepared similarly to Example 1, except that it had the raw material composition shown in Table 1. The phosphor of Comparative Example 4 was unfavorable in chromaticity X, half value width, and color rendering index (Ra).

[Comparative Example 5]

As shown in Table 1, the phosphor of Comparative Example 5 is that represented by $Lu_aCe_bAl_cSi_dO_eN_f$, wherein a = 2.70, b = 0.30, c = 3.00, d = 0.01, e = 9.15, and f = 0.013 and thus the value of c was outside the scope of the present invention. The phosphor of Comparative Example 5 was prepared similarly to Example 1, except that it had the raw material composition shown in Table 1. The phosphor of Comparative Example 5 was unfavorable in external quantum efficiency, chromaticity X, half value width, and color rendering index (Ra).

Comparison of the results of Examples 1 to 4 with those of Comparative Examples 1 and 2 in Table 1 shows that the presence of Si and N results in increase in chromaticity X, peak wavelength, half value width, and also intensity of red component. However when Si and N are present in excessive amounts, such a phosphor showed distinctive decrease in external quantum efficiency.

Comparison of the results of Examples 2, 5, and 6 with those of Comparative Examples 3 and 4 in Table 1 shows that the presence of cerium oxide in an excessively small amount results in decrease in chromaticity X, peak wavelength, half value width, and also intensity of red component, that the presence of cerium oxide in a greater amount results in increase of the intensity of red component, and that the presence of cerium oxide in an excessive amount results in decrease in external quantum efficiency.

Comparison of the results of Examples 2, 9, and 10 with those of Comparative Example 5 in Table 1 shows that the presence of Al in an excessively small amount results in distinctive decrease in external quantum efficiency and decrease in chromaticity X, as in Comparative Example 5, and also decrease in the content of red component.

[Example 20]

The invention of Example 20 relates to a light-emitting device that has the phosphor described above and a light-emitting element, as shown in Figure 1. The light-emitting device of Example 20 gave the favorable effects shown in Table 1, when it used a phosphor of Examples 1 to 11.

[Example 21]

The invention of Example 21 relates to a lighting device, specifically an electric lamp-type lighting device having the light-emitting device of Example 20, although not shown in Figure. The lighting device showed the favorable effects shown in Table 1, when it used a phosphor of Examples 1 to 11.

Reference Signs List

1: Blue LED chip
2: Phosphor
3: Conductive wire
4: Sealing resin
5: Container
6: Conductive terminal
7: Another conductive terminal

**Claims**

1. A phosphor having a garnet structure represented by General Formula: $Lu_aCe_bAl_cSi_dO_eN_f$, wherein a to f satisfy the following conditions:

$$1.50 \leq a \leq 3.15;$$

$$0.05 \leq b \leq 1.50;$$

$$2 \leq a+b \leq 4;$$

$$4.0 \leq c \leq 7.0;$$

$$0.0 < d < 0.1;$$

$$7.0 \leq e \leq 16.0;$$

$$0.001 \leq f \leq 1.0;$$

and

$$10 \leq e+f \leq 16.$$

2. The phosphor according to Claim 1, wherein part of Lu above is substituted with one or more elements selected from Y, Sc, La, Gd, and Sm.

3. The phosphor according to Claim 1 or 2, wherein part of Ce above is substituted with one or more elements selected from Pr, Nd, Eu, Tb, Dy, Ho, Er, Tm, Yb, Bi, and Mn.

4. The phosphor according to any one of Claims 1 to 3, wherein part of Al above is substituted with one or both of Ga and In.

5. The phosphor according to any one of Claims 1 to 4, comprising two or more elements of F, Cl, Li, Na, Mg, Nd, Ca, Ba, and B as flux component during sintering.

6. A light-emitting device comprising a light-emitting element and the phosphor according to any one of Claims 1 to 5.

7. A lighting device comprising the light-emitting device according to Claim 6.

[Fig. 1]

## INTERNATIONAL SEARCH REPORT

| International application No. |
| --- |
| PCT/JP2014/052898 |

**A. CLASSIFICATION OF SUBJECT MATTER**
*C09K11/80*(2006.01)i, *H01L33/50*(2010.01)i

According to International Patent Classification (IPC) or to both national classification and IPC

**B. FIELDS SEARCHED**

Minimum documentation searched (classification system followed by classification symbols)
C09K11/80, H01L33/50

Documentation searched other than minimum documentation to the extent that such documents are included in the fields searched
Jitsuyo Shinan Koho          1922-1996     Jitsuyo Shinan Toroku Koho    1996-2014
Kokai Jitsuyo Shinan Koho    1971-2014     Toroku Jitsuyo Shinan Koho    1994-2014

Electronic data base consulted during the international search (name of data base and, where practicable, search terms used)
CAplus/REGISTRY(STN)

**C. DOCUMENTS CONSIDERED TO BE RELEVANT**

| Category* | Citation of document, with indication, where appropriate, of the relevant passages | Relevant to claim No. |
| --- | --- | --- |
| A | US 2006/0197443 A1 (Gelcore, LLC), 07 September 2006 (07.09.2006), claims; examples; figures & WO 2006/094139 A2      & CN 101151348 A | 1-7 |
| A | CN 103031127 A (General Research Institute for Nonferrous Metals), 10 April 2013 (10.04.2013), claims; examples (Family: none) | 1-7 |
| A | Chemistry of Materials, 2008, 20(19), 6277-6283 | 1-7 |

☒ Further documents are listed in the continuation of Box C.          ☐ See patent family annex.

| | | |
| --- | --- | --- |
| * | Special categories of cited documents: | |
| "A" | document defining the general state of the art which is not considered   to be of particular relevance | "T" later document published after the international filing date or priority date and not in conflict with the application but cited to understand the principle or theory underlying the invention |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| 04 April, 2014 (04.04.14) | 22 April, 2014 (22.04.14) |

| Name and mailing address of the ISA/ Japanese Patent Office | Authorized officer |
| --- | --- |
| Facsimile No. | Telephone No. |

Form PCT/ISA/210 (second sheet) (July 2009)

**INTERNATIONAL SEARCH REPORT**

International application No.

PCT/JP2014/052898

C (Continuation). DOCUMENTS CONSIDERED TO BE RELEVANT

| Category* | Citation of document, with indication, where appropriate, of the relevant passages | Relevant to claim No. |
|---|---|---|
| A | JP 2010-509751 A (Koninklijke Philips Electronics N.V.), 25 March 2010 (25.03.2010), claims; paragraph [0036] & US 2010/0067233 A1 & US 2012/0134134 A1 & WO 2008/056292 A1 & CN 101542754 A | 1-7 |
| A | ECS Transactions, 2009, 16(30), 65-70 | 1-7 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012062444 A

- JP 2009539219 T

**Non-patent literature cited in the description**

- **KAZUAKI OHKUBO et al.** Absolute Fluorescent Quantum Efficiency of NBS Phosphor Standard Samples. *Journal of the Illuminating Engineering Institute of Japan,* 1999, vol. 83 (2), 87-93